# EUROPEAN PATENT SPECIFICATION

(11) **EP 0 409 582 B1**
(45) Date of publication and mention of the grant of the patent: **12.01.1994**
(21) Application number: 90307832.7
(22) Date of filing: 18.07.1990
(51) Int. Cl.: B23K 20/00, H01L 21/60

(54) **Method for forming a bump by bonding a ball on an electrode of an electronic device**
Verfahren zur Bildung eines Kontakthöckers bei der Befestigung einer Kugel auf einer Elektrode einer elektronischen Komponente
Procédé pour former un plot de contact en fixant une bille sur une électrode d'un composant électronique

(30) Priority: 19.07.1989 JP 187766/89
(43) Date of publication of application: 23.01.1991
(73) Proprietor: NEC CORPORATION, Tokyo (JP)
(72) Inventor: Kitamura, Yoshihiro, Minato-ku, Tokyo (JP)
(74) Representative: Pritchard, Colin Hubert

(56) References cited:
- GB-A- 2 095 473
- GB-A- 2 201 545
- US-A- 4 750 666
- PATENT ABSTRACTS OF JAPAN vol. 11, no. 384 (E-565)(2831) 15 December 1987,& JP-A-62 150854 (HITACHI) 04 July 1987,
- PATENT ABSTRACTS OF JAPAN vol. 10, no. 317 (E-449)(2373) 28 October 1986,& JP-A-61 128539 (MITSUBISHI ELECTRIC CORP) 16 June 1986,
- PATENT ABSTRACTS OF JAPAN vol. 12, no. 435 (E-683)(3282) 16 November 1988,& JP-A-63 168036 (TANAKA ELECTRON IND) 12 July 1988,
- PATENT ABSTRACTS OF JAPAN vol. 12, no. 17 (E-574)(2864) 19 January 1988,& JP-A-62 174931 (MITSUBISHI ELECTRIC CORP) 31 July 1987,

## Description

The invention relates to a method for forming a bump by bonding a ball on an electrode of an electronic device according to the preamble of claim 1 (see e.g. US-A-4 750 666).

### BACKGROUND OF THE INVENTION

In manufacturing electronic devices such as IC chips, a metallic bump is formed on an electrode of an electronic devices for wiring. A bump is formed usually by bonding a ball on the electrode using metallic wire. Such a type of a conventional method for forming a bump is described in the Japanese Patent Kokai No. 64-12555.

In the conventional method for forming a bump described therein, a capillary penetrated by a metallic wire is mounted above a discharge electrode. The distance between the bottom end of the capillary and the top surface of the discharge electrode is set usually from 1 mm to 2 mm, and the distance between the bottom end of the metallic wire and the top surface of the discharge electrode is set from 0.1 mm to 0.5 mm. When a discharge current flows between the metallic wire and the discharge electrode by adding a high voltage such as several thousand volts, the metallic wire gets a high temperature and melts from the bottom end thereof which is near from the discharge electrode, then the molten part of the metallic wire becomes spherical and moves up along the metallic wire. Finally, a ball is formed at the bottom end of the metallic wire. The ball and the near part of the remaining metallic wire are recrystallized and coarse particles of crystals are formed. On the other hand, the upper part of the metallic wire is not recrystallized and has fine particles.

Then, the ball is mounted and fixed on an electrode of an electronic device by adding a supersonic vibration. The capillary is moved up from the ball to a predetermined position. Then, the metallic fatigue is imposed in the metallic wire to make a crack by adding a supersonic vibration. The metallic wire is pulled to be cut at the crack as the capillary moves up. As a result, a bump is formed on the electrode after cutting of the metallic wire.

In the conventional method for forming a bump, however, there is a disadvantage in that the metallic wire can be cut at the interface of recrystallization between the part of coarse particles and that of fine particles, usually 100 µm higher above the ball, where endurance against the shearing stress is smaller than the part where the metallic fatigue is imposed. Consequently, the bump has a wire-shaped part on the main part of the bump. This causes the expansion of the bump horizontally, because the wire-shaped part is crumbled in the process of reshaping of the bump or the inner lead bonding. As a result, the bump can touch the neighbouring bump, which causes a short circuit.

Various methods have been suggested to avoid the formation of a wire projection or neck on the bump. For example, in JP 62-150 854 silicon is included in the wire to embrittle it, and in GB 2 095 473 the wire is weakened to control the position of the break-point.

It is an object of the invention to provide a method for forming a bump which has almost no wire-shaped part on the main part thereof.

According to the invention, a method for forming a bump by bonding a ball on an electrode of an electronic device, comprising the steps of:
forming a ball at a bottom end of a metallic wire held by a capillary by discharge between said metallic wire and a discharge electrode;
moving the capillary down to touch the ball;
fixing said ball on an electrode of an electronic device; and
parting said metallic wire, by horizontal shearing, to form a bump on said electrode, characterised in that said step of forming a ball at a bottom end of the metallic wire includes causing the capillary and the ball to touch whilst the ball is molten whereby to transfer heat from the ball to the capillary and to establish a recrystallisation boundary in the wire at or adjacent the interface with the ball, the step of parting the wire comprising shearing the wire horizontally at said boundary.

The invention will be explained in more detail in accordance with following drawings wherein,

Figure 1 is an explanatory view illustrating a step of forming the ball at a bottom end of a metallic wire by discharging in accordance with the conventional method.

Figure 2 is an explanatory view illustrating the lower part of a metallic wire including the ball after discharging shown in Figure 1 in accordance with the conventional method.

Figure 3 is an explanatory view illustrating a step of mounting and fixing the ball of Figure 2 on an electrode of an IC chip in accordance with the conventional method.

Figure 4 is an explanatory view illustrating a step of moving up a capillary from the ball in accordance with the conventional method.

Figure 5 is an explanatory view illustrating a step of forming a bump by cutting the metallic wire in accordance with the conventional method.

Figure 6 is an explanatory view illustrating a step of setting a metallic wire with a capillary and a discharge electrode for discharging in accordance with the invention.

Fig. 7 is an explanatory view illustrating a step of forming a ball at a bottom end of the metallic wire by discharging in accordance with the invention.

Fig. 8 is an explanatory view illustrating a step of mounting and fixing the ball on an electrode of an IC chip after discharging in accordance with the invention.

Fig. 9 is an explanatory view illustrating a step of cutting the metallic wire by moving the capillary horizontally in accordance with the invention.

Fig. 10 is an explanatory view illustrating a step of forming a bump by cutting the metallic wire in accordance with the invention.

Fig. 11A and 11B are bar graphs representing distributions of the length of wire-shaped part of bumps.

### DESCRIPTION OF THE PREFERRED EMBODIMENT

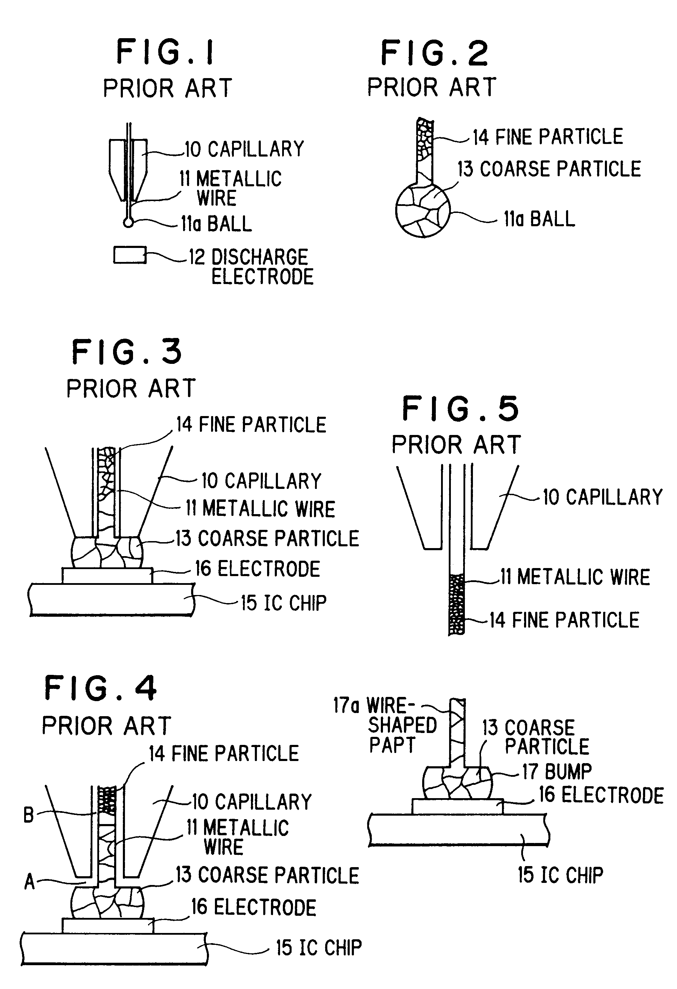

Before describing a method for forming a bump and an apparatus for forming the same according to the invention, a conventional method for forming a bump and apparatus for forming the same briefly described before will be explained in conjunction with Figs. 1 to 5.

Fig. 1 shows a step of forming a ball 11a at a bottom end of a metallic wire 11 by discharging, wherein a capillary 10 penetrated by the metallic wire 11 is mounted above a discharge electrode 12.

Fig. 2 shows the lower part of the metallic wire 11 after discharging. The ball 11a and the near part of the remaining metallic wire 11 are recrystallized, so that coarse particles 13 of crystals are formed therein. On the other hand, the upper part of the metallic wire 11 has fine particles 14 therein.

Fig. 3 shows a step of mounting the ball 11a on a electrode 16 of an IC chip 15. The ball 11a is fixed on the electrode 16 by adding a supersonic vibration.

Fig. 4 shows a step of moving up the capillary 10. A metallic fatigue is imposed at the point A just above the ball 11a in the metallic wire 11 to make a crack by adding a supersonic vibration. But, the metallic wire 11 can be cut at the point B which is an interface between the part of coarse particles 13 of crystals and that of fine particles 14.

Fig. 5 shows a step of forming a bump 17 by cutting the metallic wire 11. The metallic wire 11 is pulled to be cut at the interface of recrystallization as the capillary 10 moves up, so that the bump 17 has a wire-shaped part 17a on the main part of the bump 17.

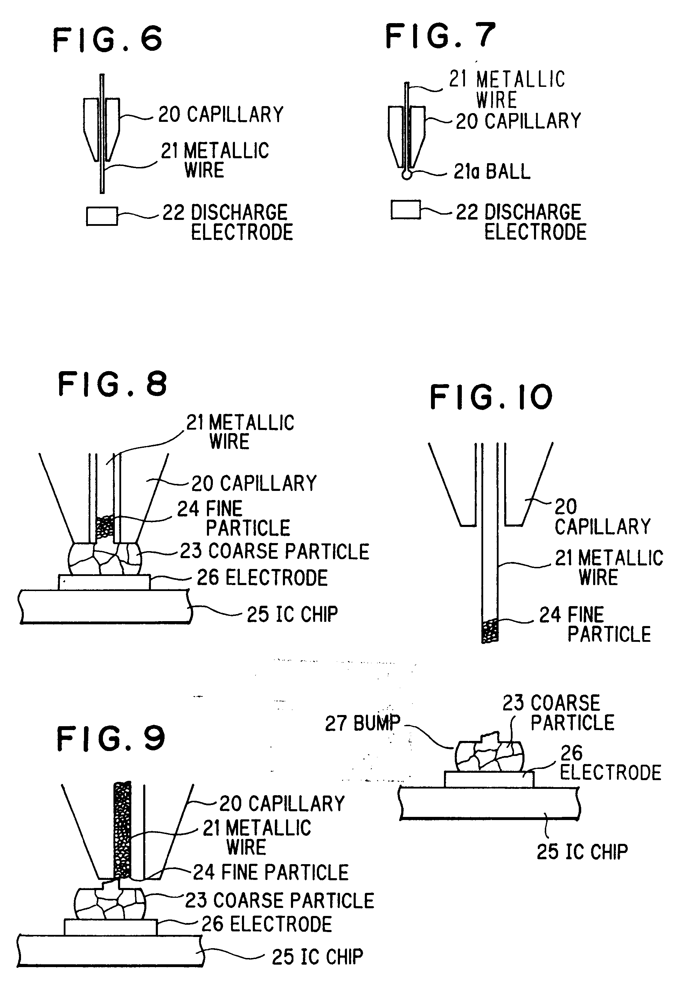

Next, preferred embodiments of the invention will be described in detail in conjunction with Figs. 6 to 11.

Fig. 6 shows a step of forming a ball at a bottom end of a metallic wire by discharging, wherein a capillary 20 penetrated by a metallic wire 21 is mounted above a discharge electrode 22. The distance between the bottom end of the capillary 20 and the top surface of the discharge electrode 22, and the distance between the bottom end of the metallic wire 21 and the top surface of the discharge electrode 22, are respectively set as the same as in the conventional method. A discharge current flows between the metallic wire 21 and the discharge electrode 22 by adding a high voltage by a power supply (not shown) to heat and melt the metallic wire 21 from the bottom end thereof, like the case of the conventional method described before.

Then, as shown in Fig. 7, the capillary 20 is moved down to touch the ball 21a at the bottom end thereof while discharging is under way, so that the heat of the ball 21a transfers to the capillary 20 and the metallic wire 21 inside the capillary 20 is not heated to avoid the recrystallization thereof. As a result, the recrystallization may not occur in the remaining metallic wire 21 inside the capillary 20 but only in the ball 21a, so that the interface of recrystallizaion is positioned just above the ball 21a. When the length of the metallic wire 21 outside the capillary 20 is limited approximately from 0.3 mm to 0.5 mm, it is not necessary to move the capillary 20. In this case, the molten part of the metallic wire 21 rises up to touch the bottom end of the capillary 20, so that the heat of the ball 21a transfers to the capillary 20 and fails to transfer to the remaining metallic wire 21 inside the capillary 20.

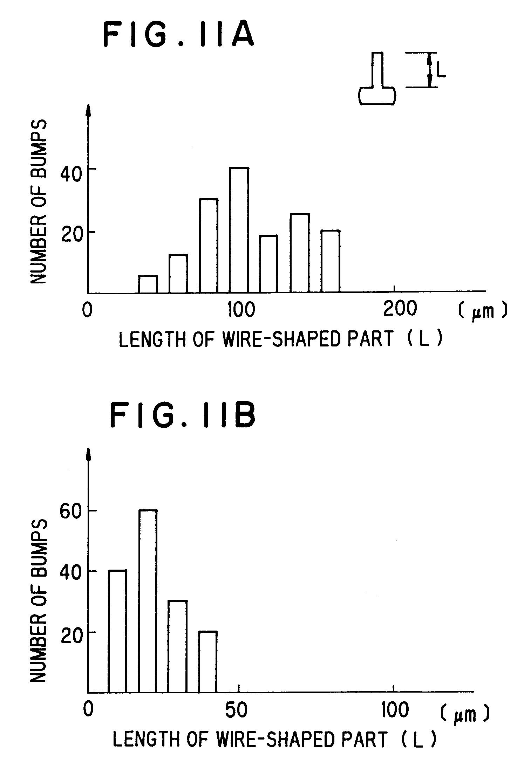

Then, the metallic wire 21 with the ball 21a at the bottom end thereof held by capillary 20 is moved from the discharge electrode 22 toward an IC chip 25, and the ball 21a is fixed on an electrode 26 of the IC chip 25 by adding a supersonic vibration, as shown in Fig. 8. The capillary 20 is slightly moved up and then moved horizontally parallel to the interface of the recrystallization, which causes the shearing stress at the interface thereof where the metallic wire 21 is to be cut, as shown in Fig. 9. Then, the capillary 20 is moved up to pull the metallic wire 21 already cut, and a bump 27 is formed, as shown in Fig.10. The resultant bump 27 has almost no wire-shaped part.

Figs. 11A and 11B show distributions of the lengths of wire-shaped part of bumps according to the conventional method and the present invention, respectively. In Fig. 11A, the averaged lengths of the wire-shaped part of bumps which is formed by the conventional method is relatively long. On the other hand, in Fig. 11B, the averaged lengths thereof according to the present invention is relatively short.

In the embodiment described above, if the metallic wire 21 is connected with the positive terminal of the power supply and the discharge electrode 22 with the negative terminal thereof during discharging, electrons converge on the bottom end of the metallic wire 21, so that only the bottom end thereof tends to be heated. As a result, the recrystallization occurs only in the ball 21a, and a bump with no wire-shaped part can be obtained like the embodiment already described before.

Although the invention has been described with respect to specific embodiment for complete and clear disclosure, the appended claims are not limited, to this specific embodiment.

## Claims

1. A method for forming a bump by bonding a ball on an electrode of an electronic device, comprising the steps of:
forming a ball (21a) at a bottom end of a metallic wire (21) held by a capillary (20) by discharge between said metallic wire and a discharge electrode (22);
moving the capillary down to touch the ball;
fixing said ball on an electrode (26) of an electronic device; and
parting said metallic wire (21), by horizontal shearing, to form a bump (27) on said electrode, characterised in that said step of forming a ball (21a) at a bottom end of the metallic wire (21) includes causing the capillary (20) and the ball (21a) to touch whilst the ball is molten whereby to transfer heat from the ball to the capillary and to establish a recrystallisation boundary in the wire at or adjacent the interface with the ball, the step of parting the wire comprising shearing the wire horizontally at said boundary.

2. A method for forming a bump by bonding a ball on an electrode of an electronic device, according to Claim 1, wherein:
the step of forming the ball (21a) at the bottom end of the wire (21) includes moving said capillary (20) down to touch said molten ball to avoid recrystallisation of said metallic wire inside the capillary.

## Patentansprüche

1. Verfahren zum Bilden eines Höckers durch Verbinden einer Kugel mit einer Elektrode einer elektronischen Einrichtung, das die Schritte aufweist:
eine Kugel (21a) am unteren Ende eines Metalldrahtes (21), der durch eine Kapillare (20) gehalten wird, durch Entladung zwischen dem Metalldraht und einer Entladungselektrode (22) zu bilden;
die Kapillare nach unten zu bewegen, daß sie die Kugel berührt;
die Kugel auf einer Elektrode (26) einer elektronischen Einrichtung zu fixieren; und
den Metalldraht (21) durch horizontales Abscheren zum Bilden eines Höckers (27) auf der Elektrode zu teilen, dadurch gekennzeichnet, daß der Schritt des Bildens einer Kugel (21a) am unteren Ende des Metalldrahtes (21) es einschließt, zu bewirken, daß sich die Kapillare (20) und die Kugel (21a) berühren, während die Kugel geschmolzen ist, wodurch Wärme von der Kugel zur Kapillare übertragen werden soll und um eine Rekristallisationsgrenze im Draht an der oder in der Nähe der Grenzfläche zur Kugel zu erzeugen, wobei der Schritt zum Teilen des Drahts das Abscheren des Drahts horizontal an der Grenze aufweist.

2. Verfahren zum Bilden eines Höckers durch Verbinden einer Kugel mit einer Elektrode einer elektronischen Einrichtung nach Anspruch 1, bei dem der Schritt des Bildens der Kugel (21a) am unteren Ende des Drahtes (21) es einschließt, die Kapillare (20) nach unten zu bewegen, daß sie die geschmolzene Kugel berührt, um Rekristallisation des Metalldrahtes innerhalb der Kapillare zu vermeiden.

## Revendications

1. Procédé pour former un bossage en liant une bille à une électrode d'un dispositif électronique, comprenant le étapes consistant à :
- former une bille (21a) à l'extrémité inférieure d'un fil métallique (21) maintenu par un capillaire (20) par décharge entre ledit fil métallique et une électrode de décharge (22);
- descendre le capillaire de façon qu'il vienne en contact avec la bille;
- fixer ladite bille à une électrode (26) d'un dispositif électronique; et
- séparer ledit fil métallique (21), en le cisaillant horizontalement, pour former un bossage (27) sur ladite électrode, caractérisé en ce que ladite étape consistant à former une bille (21a) à l'extrémité inférieure du fil métallique (21) comprend le fait d'amener le capillaire (20) et la bille (21a) à se toucher alors que la bille est à l'état fondu, d'où il résulte un transfert de la chaleur de la bille au capillaire et l'établissement d'une limite de recristallisation dans le fil au droit de l'interface avec la bille ou au voisinage de celle-ci, l'étape consistant à séparer le fil comprenant le cisaillement du fil horizontalement à ladite limite.

2. Procédé pour former un bossage en liant une bille à une électrode d'un dispositif électronique, selon la revendication 1, dans lequel :
- l'étape consistant à former la bille (21a) à l'extrémité inférieure du fil (21) comprend la descente dudit capillaire (20) pour sa venue en contact avec ladite bille à l'état fondu afin d'éviter la recristallisation dudit fil métallique à l'intérieur du capillaire.
